(19) Europäisches Patentamt
European Patent Office
Office européen des brevets

(11) Veröffentlichungsnummer: **0 167 779**
**B1**

(12) # EUROPÄISCHE PATENTSCHRIFT

(45) Veröffentlichungstag der Patentschrift: **28.12.88**

(51) Int. Cl.[4]: **C 08 F 20/24,** G 03 F 7/10, C 08 F 20/28

(21) Anmeldenummer: **85106568.0**

(22) Anmeldetag: **29.05.85**

(54) **Polymerisierbare, Perfluoralkylgruppen aufweisende Verbindungen, sie enthaltende Reproduktionsschichten und deren Verwendung für den wasserlosen Offsetdruck.**

(30) Priorität: **08.06.84 DE 3421511**

(43) Veröffentlichungstag der Anmeldung: **15.01.86 Patentblatt 86/3**

(45) Bekanntmachung des Hinweises auf die Patenterteilung: **28.12.88 Patentblatt 88/52**

(84) Benannte Vertragsstaaten: **DE FR GB**

(56) Entgegenhaltungen:
**EP-A- 0 040 841**
**US-A- 3 370 970**
**US-A- 3 901 864**
**US-A- 4 356 296**

(73) Patentinhaber: **HOECHST AKTIENGESELLSCHAFT, Postfach 80 03 20, D-6230 Frankfurt am Main 80 (DE)**

(72) Erfinder: **Müller, Werner H., Dr. Dipl.-Chem., 22 Coveside Ct., East Greenwich R.I. 02818 (US)**

**EP 0 167 779 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Polymerisierbare, Perfluoralkylgruppen aufweisende Verbindungen, sie enthaltende Reproduktionsschichten und deren Verwendung für den wasserlosen Offsetdruck.

Die Erfindung betrifft polymerisierbare, Perfluoralkylgruppen aufweisende Verbindungen mit mindestens zwei ethylenisch-ungesättigten Gruppen und ein Verfahren zu deren Herstellung; ausserdem betrifft sie strahlungsempfindliche Reproduktionsschichten, die diese Verbindungen enthalten, und deren Verwendung für den wasserlosen Offsetdruck.

Beim wasserlosen Flachdruck, insbesondere Offsetdruck wird – im Unterschied zum üblicherweise eingesetzten Offsetdruck – beim Drucken die Differenzierung in Bild- und Nichtbildstellen nicht durch das gleichzeitige Einwirken von Wasser oder wasserhaltigen Flüssigkeiten einerseits und Druckfarbe andererseits bewirkt, sondern die Differenzierung erfolgt in der Regel durch eine unterschiedliche Wechselwirkung zwischen farbannehmenden bzw. oleophilen und (nichtwasserfeuchten) farbabweisenden bzw. oleophoben Stellen auf einer Druckplattenoberfläche mit der Druckfarbe. Aus dem Stand der Technik sind dazu beispielsweise die folgenden Druckschriften bekannt:

In der DE-C 1 571 890 (= US-A 3 677 178) wird eine Druckplatte beschrieben, die auf einem Trägermaterial aus einem Metall, einem Kunststoff oder Papier eine Schicht aus einem hydrophoben und oleophoben Silikonkautschuk und eine strahlungsempfindliche Reproduktionsschicht in dieser oder der umgekehrten Reihenfolge aufweist. Die Reproduktionsschicht enthält als strahlungsempfindliche Verbindung Ammoniumdichromat, Formaldehydkondensate von Diphenylamin-4-diazoniumsalzen oder Polyvinylcinnamat. Die beim Drucken farbführenden Stellen sind entweder freigelegte Teile des Trägermaterials oder durch das Bestrahlen gehärtete Teile der Reproduktionsschicht.

Die Druckplatte gemäss der DE-B 1 671 637 (= US-A 3 511 178 und 3 682 633) weist auf einem Trägermaterial zunächst eine strahlungsempfindliche Reproduktionsschicht und darauf eine Beschichtung auf, die gegenüber Druckfarben einen geringeren Ablösewert (geringere adhäsive Wechselwirkung) als das Trägermaterial hat. Die letztgenannte Beschichtung besteht entweder aus einem Polysiloxan (Silikonelastomer) oder einer fluorhaltigen organischen Verbindung wie einem Homopolymer aus dem Methacrylsäureester des Perfluoroctanols.

Weitere Ausgestaltungen von Druckplatten für den wasserlosen Offsetdruck bzw. von dafür geeigneten Verbindungen sind beispielsweise den folgenden Druckschriften zu entnehmen:

Aus der DE-A 2 354 838 (= US-A 3 953 212) ist die Kombination einer strahlungsempfindlichen Verbindung mit einem Silikonkautschuk in einer Schicht auf einem der üblichen Trägermaterialien bekannt. Die Druckplatte gemäss der DE-B 2 422 428 (= GB-A 1 464 123) enthält in einer Schicht ein photopolymerisierbares Polysiloxan und einen Photosensibilisator.

In der DE-A 2 524 562 (= GB-A 1 501 128) werden strahlungsempfindliche Beschichtungen beschrieben, die ein aromatisches Diazoniumkation, ein Anion einer Perfluoralkylgruppen aufweisenden Carbon- oder Sulfonsäure und gegebenenfalls ein polymeres organisches Bindemittel enthalten. Von dieser Schicht soll nach dem Bestrahlen direkt, d.h. ohne Entwicklungsschritt, gedruckt werden können.

In einer oleophoben Beschichtung enthalten die Druckplatten nach der DE-A 2 648 278 (= US-A 4 087 584) ein fluorhaltiges Homo- oder Copolymerisat mit Monomereneinheiten, die sich von Acrylsäure- oder Methacrylsäureestern mit Perfluoralkyl-, 4-Perfluoralkoxy-benzoyloxy-alkyl- oder Perfluoralkan-sulfonamido-alkyl-Gruppen ableiten. Bei Copolymerisaten ist der Anteil der fluorhaltigen Monomereneinheiten grösser als 75%. Diese oleophobe Beschichtung befindet sich entweder direkt auf einem Trägermaterial und Bildbezirke werden auf die Beschichtung aufgetragen oder sie befindet sich oberhalb einer elektrophotographisch-arbeitenden Reproduktionsschicht, so dass dann auch der oleophoben Beschichtung Tonerbilder erzeugt werden.

Aus der US-A 3 910 187 sind verschiedene Möglichkeiten bekannt, aus üblichen Photopolymerdruckplatten (d.h. Druckplatten aus einem Trägermaterial und einer Reproduktionsschicht mit einem Gehalt an photopolymerisierbaren Verbindungen) durch Aufbringen einer Zwischen- oder Abschlussschicht Druckplatten für die Anwendung im wasserlosen Offsetdruck zu erzeugen. Diese Zwischen- oder Abschlussschichten enthalten entweder Perfluoralkylgruppen aufweisende Carbon-, Sulfon-, Phosphonsäuren und Amine oder Polymerisate aus Perfluoralkylgruppen aufweisenden Acrylsäure- oder Methacrylsäureestern, Maleinsäurediestern, Vinylethern, Carbonsäurevinylestern, Sulfonamidoallylestern u.ä.; die Polymerisate werden entweder bereits vor dem Aufbringen auf die Druckplatte durch Photopolymerisation hergestellt.

Der EP-A 0 037 094 ist zu entnehmen, dass strahlungsempfindliche Polymere (u.a. für den Einsatz als Beschichtung für Druckplatten) hergestellt werden können, die Copolymerisate aus a) Acrylsäure- oder Methacrylsäure-perfluoralkylestern und b) Acrylsäure- oder Methacrylsäureazidobenzoyloxy-alkylestern sind. Strahlungsempfindliche Reproduktionsschichten können neben diesen Copolymerisaten auch noch alkalisch-entwickelbare organische Bindemittel und übliche Hilfsmittel enthalten. Nach der Bestrahlung und Entwicklung wird auf dem Trägermaterial ein Reliefbild erzeugt. In der EP-A 0 040 841 werden strahlungsempfindliche Polymere beschrieben, die Copolymerisate aus a) Monomeren mit endständigen Perfluoralkylgruppen und endständigen ethylenisch-ungesättigten Gruppen und b) Monomeren mit strahlungsempfindlichen Gruppen und ethylenisch-ungesättigten

Gruppen sind. Zu der ersten Gruppe von Monomeren zählen beispielsweise Acrylsäure oder Methacrylsäure-perfluoralkylester und zu der zweiten Gruppe beispielsweise Methacrylsäureazidobenzoyloxyalkylester, Acrylsäure-cinnamoyloxy-alkylester, Methacrylsäure-benzoylphenylester oder Methacrylsäure-cinnamoylphenylester. Aus der EP-A 0 096 845 sind strahlungsempfindliche Polymere bekannt, die Copolymerisate aus a) Acrylsäure- oder Methacrylsäure-2-perfluoralkoxy-2-fluor-ethyl-1-estern oder verwandten Verbindungen, b) Monomeren mit strahlungsempfindlichen Gruppen und ethylenisch-ungesättigten Gruppen und c) gegebenenfalls weiteren fluorfreien copolymerisierbaren Vinylmonomeren sind.

Die bisher bekanntgewordenen Fluor enthaltenden Verbindungen für strahlungsempfindliche Reproduktionsschichten, die auf dem Gebiet des wasserlosen Offsetdrucks eingesetzt werden sollen, sind teilweise zu wenig strahlungsempfindlich, d.h. sie benötigen zu lange Bestrahlungs(Belichtungs)zeiten zur Differenzierung in Bild- und Nichtbildstellen für den nachfolgenden Druckvorgang. Ein wesentlicher Nachteil ist auch, dass im Regelfall organische Lösemittel wie 2-Butoxyethanol-(1), Ethylenglykolmonoethylether, Methylenchlorid, Dioxan oder Hexafluor-m-Xylol im Entwicklungsschritt eingesetzt werden müssen. Ausserdem sind die Ausgangskomponenten oftmals nur schwer (d.h. zum Beispiel über mehrere Stufen) zu synthetisieren, so dass sie für eine grosstechnische Anwendung nicht oder nur in untergeordnetem Masse in Betracht gezogen werden können. Mit Reproduktionsschichten, die kein Bindemittel enthalten und/oder nach deren Bestrahlung kein zusätzlich differenzierender Entwicklungsschritt durchgeführt wird, sind im allgemeinen keine höheren Druckauflagen zu erzielen.

In der US-A 4 356 296 sind Bis(meth)acrylsäureester von aromatischen Dialkoholen mit $\alpha$-ständigen Perfluormethyl- oder -ethylgruppen beschrieben, die zu Kunststoffen polymerisiert werden können, die als Zahn- oder Knochenprothesematerialien verwendbar sind. Die Polymerisation erfolgt thermisch oder durch UV-Licht. Die Monomeren sind wegen der stark hydrophoben Natur ihrer durch Fluorkohlenstoffgruppen substituierten aromatischen Grundkörper für eine Verarbeitung mit wässrigen Entwicklerlösungen nicht geeignet. Ausserdem ist ihre starke Kristallisationstendenz in lichtempfindlichen Schichten störend.

Aufgabe der vorliegenden Erfindung ist es deshalb, neue strahlungsempfindliche Verbindungen, insbesondere für den Einsatz auf dem Gebiet des wasserlosen Offsetdrucks, zu synthetisieren, die eine gute praktische Strahlungs(Licht)empfindlichkeit aufweisen, aus im Handel erhältlichen Ausgangsstoffen (Edukten) hergestellt und in Reproduktionsschichten nach der Bestrahlung möglichst mit wässrigen Lösungen (insbesondere mit wässrig-alkalischen Lösungen) entwickelt werden können.

Gegenstand der Erfindung sind polymerisierbare, Perfluoralkylgruppen aufweisende Verbindungen mit mindestens zwei endständigen ethylenisch-ungesättigten Gruppen, die dadurch gekennzeichnet sind, dass sie mindestens zwei Acryloyl- oder Methacryloylgruppen und mindestens eine über eine funktionelle Gruppe an das Molekül gebundene Perfluoralkylgruppe aufweisen. Unter dem Begriff «über eine funktionelle Gruppe an das Molekül gebunden» ist für die vorliegende Erfindung zu verstehen, dass sich zwischen den Acryloyl- bzw. Methacryloylgruppen und der bzw. den Perfluoralkylgruppe(n) noch mindestens eine funktionelle Gruppe befindet, die nicht unmittelbar der Acryloyl- bzw. Methacryloylgruppe benachbart ist und ursprünglich zum in das Molekül eingeführten Perfluoralkylrest gehörte; funktionelle Gruppen sind dabei solche, die mindestens ein Heteroatom wie O, N, P oder S enthalten. Insbesondere ist (sind) die Perfluoralkylgruppe(n) über eine Ester- oder Amidfunktion an das Molekül gebunden, wobei die Esterfunktion bevorzugt ist. Dabei befinden sich die genannten Substituentengruppen der Verbindungen an verschiedenen C-Atomen der Moleküle dieser Verbindungen, und die Perfluoralkylgruppe ist direkt oder über ein unverzweigtes oder verzweigtes, gesättigtes oder ungesättigtes Alkylenzwischenglied mit 1 bis 5 C-Atomen mit der funktionellen Gruppe, insbesondere mit dem C-Atom des Carbonylgruppenteils der Ester- oder Amidfunktion, verbunden; es sind aber auch solche Moleküle möglich, bei denen die Perfluoralkylgruppe mit dem O- bzw. N-Atom der Ester- oder Amidfunktion verbunden ist. Die Perfluoralkylgruppen sind ungesättigt oder gesättigt, verzweigt oder unverzweigt und weisen im allgemeinen 4 bis 20 C-Atome, insbesondere 5 bis 15 C-Atome, auf; sie sind bevorzugt unverzweigte Molekülreste und haben maximal zwei Doppelbindungen pro Molekülrest. In den Perfluoralkylgruppen können gegebenenfalls auch durch Etherbrücken verknüpfte Difluormethylengruppen vorhanden sein.

Die als Monomere oder Oligomere (d.h. über ein mindestens bifunktionell reagierendes Zwischenglied verknüpfte Monomere wie mit einem Diisocyanat zur Reaktion gebrachte, noch freie Hydroxylgruppen enthaltende Monomere) vorliegenden erfindungsgemässen Verbindungen unterscheiden sich von den meisten der bekannten Verbindungen des Standes der Technik dadurch, dass sie im Molekül mindestens zwei Acryloyl- oder Methacryloylgruppen und mindestens eine Perfluoralkylgruppe aufweisen und von dem aus der US-A 3 910 187 bekannten 2-(2′-Perfluorhexyl-ethyl-1′)-1,3-propandiol-diacrylat dadurch, dass die Perfluoralkylgruppe nicht ausschliesslich über eine Alkylengruppe an den Molekülrest gebunden ist, sondern – wie vorstehend definiert – über eine funktionelle Gruppe. Diese Verbindungen sind insbesondere die folgenden mindestens eine Perfluoralkylgruppe aufweisenden Verbindungen:

A: Acrylsäure- oder Methacrylsäureester oder

-teilester eines mehrwertigen (mindestens dreiwertigen) Alkohols mit 3 bis 12 C-Atomen,
B: Additionsprodukte von aktiven Wasserstoff enthaltenden Verbindungen (z.B. von Alkoholen, Thiolen, Aminen, Carbonsäuren, Sulfonsäuren, Phosphonsäuren oder Phenolen) mit Glycidylacrylat oder -methacrylat,
C: Additionsprodukte von Monoepoxy- oder Polyepoxyverbindungen mit Acrylsäure oder Methacrylsäure,
D: Ester von N-Methylolacrylamid oder -meth - acrylamid mit Hydroxycarbonsäuren,
E: Additionsprodukte von N-Methylolacrylamid oder -methacrylamid mit Monoepoxy- oder Polyepoxyverbindungen.

Von diesen Verbindungen sind die bevorzugt, die mindestens drei Acryloyloxy- oder Methacryloyloxygruppen besitzen. Die Perfluoralkylgruppe wird insbesondere in mindestens eine Hydroxylgruppe enthaltende, meist technisch einfach verfügbare Komponenten durch Umsetzung mit einer geeigneten Perfluoralkansäure bzw. einer solchen Säure, die zwischen dem Perfluoralkylrest und der Carboxylgruppe noch ein Alkylenzwischenglied aufweist, oder insbesondere deren Säurehalogenid (bevorzugt Säurechlorid) eingeführt.

Zu den unter A genannten Verbindungen zählen (zusätzlich muss im folgenden jeweils davon ausgegangen werden, dass die Moleküle mindestens eine Perfluoralkylgruppe tragen, die über eine funktionelle Gruppe gebunden ist) beispielsweise folgende:

Acrylsäure- oder Methacrylsäureester oder -teilester von Glycerin, Trimethylolmethan, Trimethylolethan, Trimethylolpropan oder Pentaerythrit; zu B Addukte von Glycidylacrylat oder -methacrylat mit Ethylenglykol, Trimethylolmethan, Pentaerythrit, Ethanolamin, Triethanolamin, Ethandithiol, Ethylendiamin, Xylylendiamin, Phenylendiamin, 1,6-Diaminohexan, 1,12-Diaminododecan, 1,3-Bis-(aminomethyl)cyclohexan, 1,4-Bis(aminomethyl)cyclohexan, Bis(4-aminocyclohexyl)methan, Malonsäure, Bernsteinsäure, Glutarsäure, Adipinsäure, Decandisäure, Dodecandisäure, Maleinsäure, Fumarsäure, Itakonsäure, Äpfelsäure, Weinsäure, Citronensäure, Phthalsäure, Isophthalsäure, Naphthalindicarbonsäure sowie mit folgenden Tetracarbonsäuren bzw. deren Mono- und Diestern: Pyromellitsäure, 3,3′,4,4′-Diphenyltetracarbonsäure, 1,2,5,6-Naphthalintetracarbonsäure, 2,2′,3,3′-Diphenyltetracarbonsäure, 2,2-Bis(3,4-dicarboxyphenyl)propan, 2,2-Bis(2,3-dicarboxyphenyl)propan, Bis(3,4-dicarboxyphenyl)sulfon, Perylentetracarbonsäure, Bis(3,4-dicarboxyphenyl)ether, 1,1-Bis(2,3-dicarboxyphenyl)ethan, 1,1-Bis(3,4-dicarboxyphenyl)ethan, Bis-(2,3-dicarboxyphenyl)methan, Bis(3,4-dicarboxyphenyl)-methan, 3,4,3′,4′-Benzophenontetracarbonsäure, 2,2-Bis-(3,4-dicarboxyphenyl)hexafluoropropan, Phenol, Thiophenol, Hydrochinon, Brenzkatechin, Gallussäure, Pyrogallol, Bisphenol A, 2,3-Bis(4-hydroxyphenyl)hexafluoropropan; zu C Addukte von Glycidylestern mit wenigstens zwei Epoxygruppen und 9 bis 14 C-Atomen an Acryl- oder Methacrylsäure wie ein Addukt von Acryl- und Methacrylsäure mit Glycidylestern von Phthalsäure, Tetrahydrophthalsäure, Bernsteinsäure, Adipinsäure, Maleinsäure, Fumarsäure oder Itakonsäure oder Addukte von Glycidylethern mit wenigstens 2 Epoxygruppen an Acryl- oder Methacrylsäure wie ein Addukt von Acryl- oder Methacrylsäure an Glycidylether von 2,2-Bis(4-hydroxyphenyl)propan oder 2,2-Bis-(4-hydroxyphenyl)hexafluoropropan; zu D Diester von N-Methylolacrylamid oder -methacrylamid mit Äpfelsäure, Weinsäure oder Zitronensäure; zu E Addukte von N-Methylolacrylamid oder -methacrylamid an Glycidylester von Acrylsäure, Methacrylsäure, Phthalsäure, Tetrahydrophthalsäure, Maleinsäure, Fumarsäure oder Itakonsäure.

Ausser den vorstehend aufgeführten Klassen von mindestens eine Perfluoralkylgruppe aufweisenden Verbindungen A bis E gibt es auch noch weitere Klassen:
F: Additionsprodukte von Isocyanatoethylacrylaten oder -methylacrylaten mit mindestens dreiwertigen Alkoholen oder Aminen, die noch mindestens eine reaktionsfähige OH- oder NH-Funktion zur Einführung der Perfluoralkylgruppe besitzen müssen,
G: Perfluoralkylgruppen aufweisende Di- oder Polyole, Di- oder Polycarbonsäuren, Di- oder Polyamine mit mindestens zwei freien NH-Funktionen zur Umsetzung von Isocyanatoethylacrylaten zu den entsprechenden Urethanen, Amiden oder Harnstoffen,
H: Perfluoralkylgruppen aufweisende ein- oder mehrwertige Alkohole oder Amine, die mit Acryl- oder Methacrylsäuren oder ihren Derivaten zur Bildung von Estern oder Amiden umgesetzt werden,
I: Perfluoralkylgruppen und Hydroxylgruppen aufweisende Ester von Polycarbonsäuren, die mit Acryl- oder Methacrylsäuren oder ihren Derivaten zur Bildung von Estern umgesetzt werden.

Bei Bildung der Verbindungsklassen G, H und I treten auch Strukturen auf, bei denen der Perfluoralkylrest nicht direkt bzw. über ein Alkylenzwischenglied am C-Atom der Ester- oder Amidgruppen sitzt, sondern über ein O oder N daran gebunden ist; sie werden dadurch hergestellt, dass der Perfluoralkylrest bereits vor der abschliessenden Reaktion in einem der Reaktionspartner durch einen Perfluoralkylalkohol eingeführt wird. Bestimmte Verbindungen der allgemeinen Klassen können beispielsweise mit Diisocyanaten auch zu Oligomeren verknüpft werden.

Strukturformeln für die vorstehend aufgeführten Klassen A bis I sind beispielsweise die folgenden (I bis XII), weitere Formeln auch im experimentellen Teil:

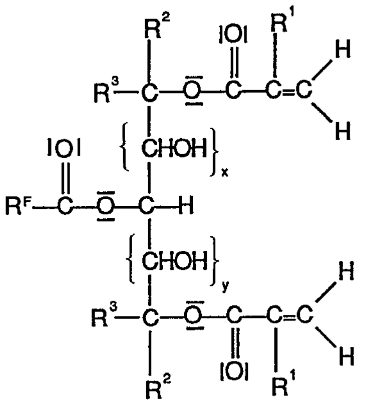

(I)

$R^F = F(C_wF_{2w})(-CH_2)_z$ oder $F(C_{w-1}F_{2w-2}) - CF = CH$, wobei die Difluormethylengruppen gegebenenfalls auch über Etherbrücken verknüpft sein können

$R^1$ = H oder $CH_3$; $R^2$, $R^3$ = H, $CH_3$, $C_2H_5$; x, y = 0, 1, 2; z = 0 bis 5; w = 5 bis 15

(II)

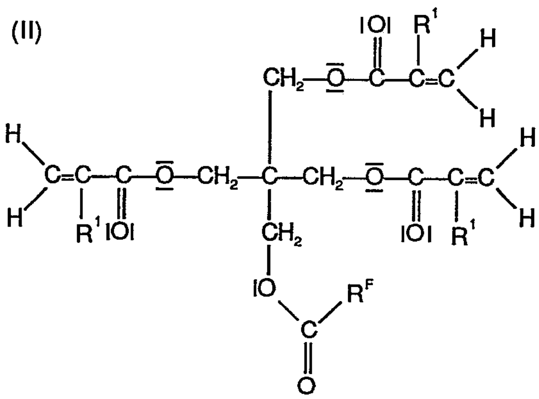

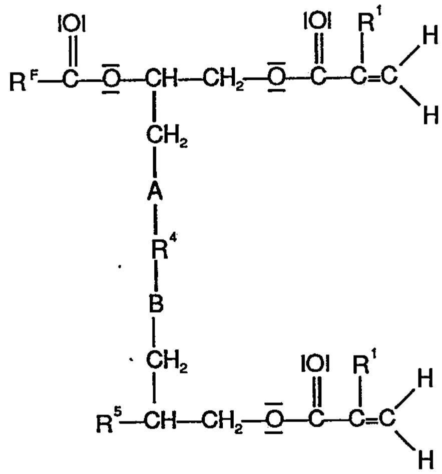

(III)

A, B = COO, $SO_2$, $PO_2H$, NH, O, S; $R^4$ = Alkylen von $C_2$ bis $C_{12}$, Phenylen, Naphthylen, Biphenylen (auch mit Ether-, Thioether- oder Carbonylgruppen überbrückt); $R^5$ = Alkoyloxy von $C_2$ bis $C_{12}$; Benzoyl- oder Naphthoyloxy, $R^F$–COO

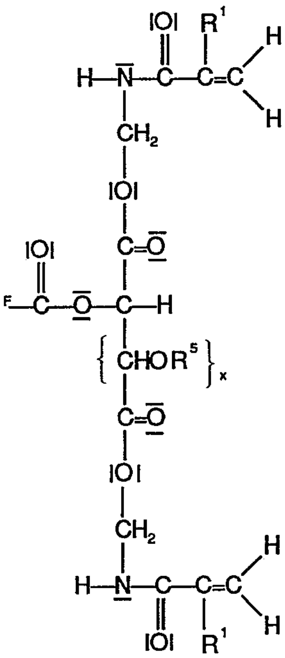

(IV)

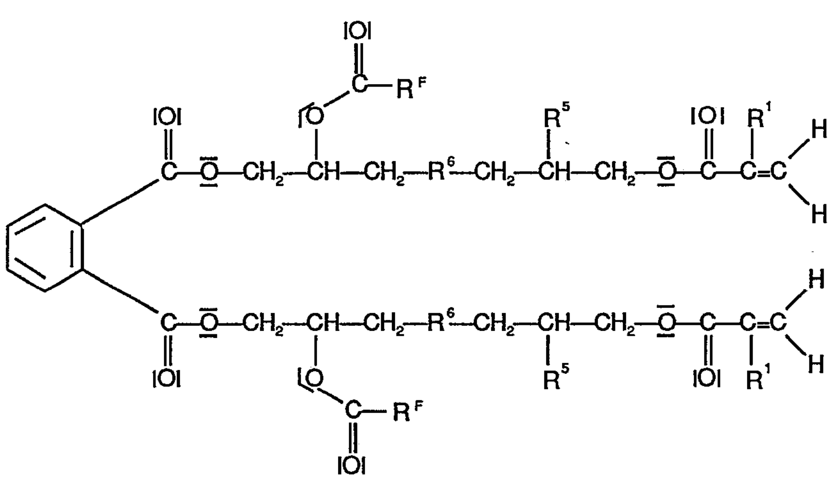

(V)

$R^6 = R^4$, $A—R^4—B$

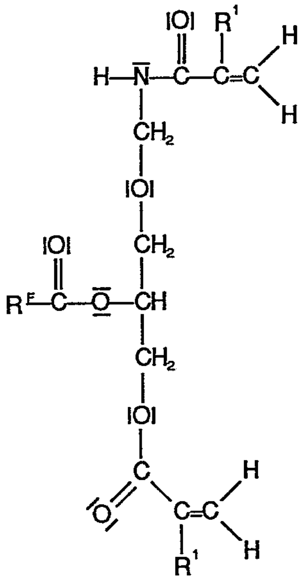

(VI)

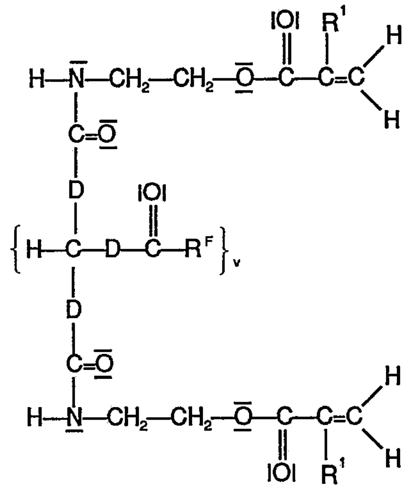

(VII)

D = 0, NH; v = 1 bis 3

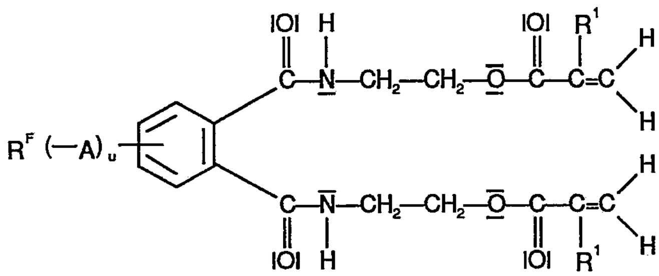

(VIII)

u = 0 oder 1

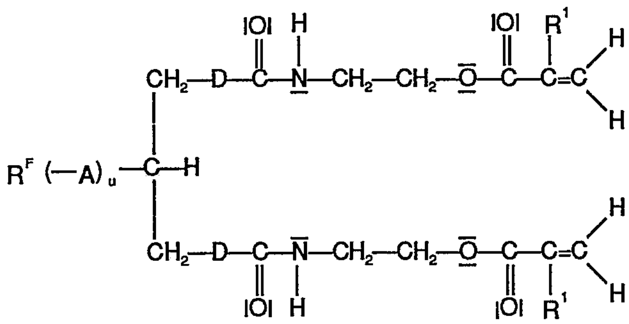

(IX)

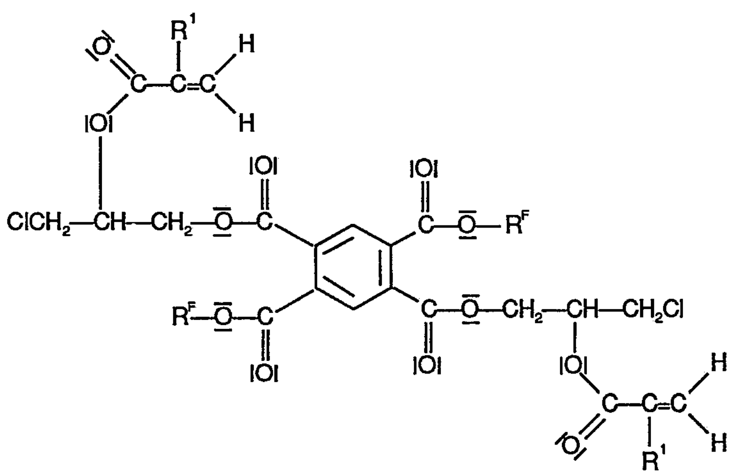

(XI)

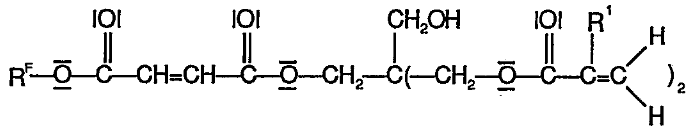

(X)

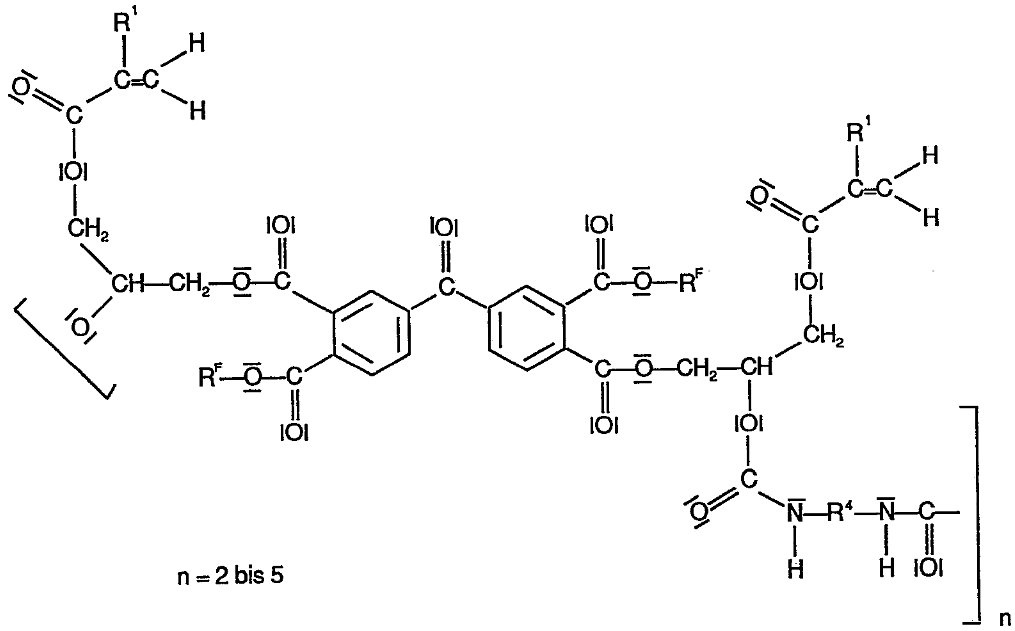

n = 2 bis 5

(XII)

Die erfindungsgemässen, Perfluoralkylgruppen enthaltenden Acrylate bzw. Methacrylate sind polymerisierbar, insbesondere in Anwesenheit eines Photoinitiators. Dadurch können sie zur Herstellung von hydrophoben und oleophoben Massen wie Lacken, Imprägnierungen oder Beschichtungen, insbesondere aber in strahlungsempfindlichen Reproduktionsschichten verwendet werden. Ein weiterer Gegenstand der Erfindung sind deshalb strahlungsempfindliche Reproduktionsschichten mit einem Gehalt an a) mindestens einer polymerisierbaren, Perfluoralkylgruppen aufweisenden Verbindung mit mindestens zwei endständigen, ethylenischungesättigten Gruppen und b) mindestens einem Photoinitiator, die dadurch gekennzeichnet sind, dass die Verbindung a) mindestens zwei Acryloyl- oder Methacryloylgruppen und mindestens eine über eine funktionelle Gruppe an das Molekül gebundene Perfluoralkylgruppe aufweist und die Reproduktionsschicht c) gegebenenfalls mindestens ein organisches polymeres Bindemittel enthält. Ausser den unter a) definierten polymerisierbaren Verbindungen können die genannten Massen, insbesondere Reproduktionsschichten, auch noch weitere polymerisierbare perfluoralkylgruppenfreie Monomere und Oligomere enthalten, die gegebenenfalls mit den unter a) genannten Verbindungen auch copolymerisierbar sind. In einer bevorzugten Ausführungsform enthält die Komponente a) eine Verbindung aus den genannten Monomeren und eine Verbindung aus den genannten Oligomeren. Die genannten Massen enthalten im allgemeinen dann 20 bis 100%, insbesondere 30 bis 60%, an polymerisierbaren Verbindungen und 0 bis 80%, i nbesondere 40 bis 70%, an organischen polymeren Bindemitteln (bei Reproduktionsschichten bevorzugt 20 bis 80% an polymerisierbaren Verbindungen und 80 bis 20% an organischen polymeren Bindemitteln). Insbesondere bei dem Einsatz der erfindungsgemässen Verbindungen in Reproduktionsschichten werden als Bindemittel ebenfalls Fluor, bevorzugt Perfluoralkylgruppen enthaltende organische Polymere, gewählt, da dies häufig zu einer besseren Vermischbarkeit der Komponenten und damit zu einer auch optisch gleichmässigeren Beschichtung führt. Der Anteil des Photoinitiators beträgt im allgemeinen 0,1 bis 10%.

Als Beispiele für geeignete Bindemittel seien genannt: Polyamide, Polyvinylester, Polyvinylacetate, Polyvinylether, Polyacrylsäureester, Polymethacrylsäureester, Polyester, Alkydharze, Polyacrylamid, Polyvinylalkohol, Polyethylenoxid, Polydimethylacrylamid, Polyvinylmethylformamid, Polyvinylmethylacetamid sowie Mischpolymerisate der Monomeren, die die aufgezählten Homopolymerisate bilden. Ferner kommen als Bindemittel Naturstoffe oder umgewandelte Naturstoffe in Betracht, z.B. Gelatine oder Celluloseether.

Mit Vorteil werden Bindemittel verwendet, die in wässrigalkalischen Lösungen löslich oder mindestens quellbar sind, da sich Schichten mit solchen Bindemitteln mit den bevorzugten wässrig-alkalischen Entwicklern entwickeln lassen. Derartige Bindemittel können z.B. die folgenden Gruppen enthalten: $-COOH$, $-PO_3H_2$, $-SO_3H$, $-SO_2NH_2$, $-SO_2-NH-CO-$. Als Beispiele hierfür seien genannt: Maleinatharze, Polymerisate aus

N-(p-Tolylsulfonyl)-carbaminsäure-(β-methacryloyloxyethyl)-ester und Mischpolymerisate dieser und ähnlicher Monomeren mit anderen Monomeren, ferner Methylmethacrylat-Methacrylsäure-Copolymerisate oder Mischpolymerisate aus Methacrylsäure, Alkylmethacrylaten und Methylmethacrylat und/oder Styrol, Acrylnitril u.a.

Besonders bevorzugt sind in den Reproduktionsschichten die in den gleichzeitig eingereichten DE-A 3 421 526 (EP-A 167 777) und DE-A 3 421 448 (EP-A 164 059) erstmalig beschriebenen Perfluoralkylgruppen enthaltenden Polymeren, die beispielsweise Copolymerisate aus Perfluoralkylacrylaten/Acrylsäure/Styrol oder Copolymerisate aus Perfluoralkylacrylaten und Acrylaten mit mindestens einer phenolischen OH-Gruppen oder Cokondensate aus einer phenolischen Komponente mit Perfluoralkylgruppen und einer kondensationsfähigen Verbindung sind.

Als Photoinitiatoren können eine Vielzahl von Substanzen Verwendung finden. Beispiele sind Benzoin, Benzoinether, Mehrkernchinone wie 2-Ethyl-anthrachinon, Acridinderivate wie 9-Phenyl-acridin, 9-p-Methoxyphenylacridin, 9-Acetylamino-acridin, Benz(a)acridin; Phenazinderivate wie 9,10-Dimethyl-benz(a)phenazin, 9-Methylbenz(a)phenazin, 10-Methoxy-benz(a)phenazin, Chinoxalinderivate wie 6,4',4''-Trimethoxy-2,3-diphenyl-chinoxalin, 4',4''-Dimethoxy-2,3-diphenyl-5-aza-chinoxalin, Chinazolinderivate oder halogenierte Triazinderivate wie 2-(4-Ethoxynaphth-1-yl)-4,6-bis-trichlormethyl-s-triazin.

Die genannten Massen, insbesondere die Reproduktionsschichten, können ausser Monomeren und/oder Oligomeren, Bindemitteln und Photoinitiatoren noch eine Reihe weiterer üblicher Zusätze enthalten, z.B. Inhibitoren zur Verhinderung der thermischen Polymerisation der Monomeren, Wasserstoffdonatoren, sensitometrische Regler, Farbstoffe, Farbpigmente und ungefärbte Pigmente. Die Summe aller Komponenten soll 100% ergeben. Diese Bestandteile sind zweckmässig so auszuwählen, dass sie in dem für den Initiierungsvorgang wichtigen aktinischen Strahlungsbereich möglichst nicht zu stark absorbieren. Als aktinische Strahlung soll jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Die genannten photopolymerisierbaren Massen ergeben Reproduktionsschichten mit hoher Lichtempfindlichkeit. Diese ist in einigen Fällen auch dann gegeben, wenn auf eine Sauerstoff abschirmende Deckschicht verzichtet wird. Die Reproduktionsschichten zeigen auch ohne Deckschicht praktisch keine Klebeneigung und sind im belichteten Zustand beständig gegen alkalische Entwickler und saure alkoholische Wischwässer. Die Herstellung der Reproduktionsschichten erfolgt in bekannter Weise. So kann man die Komponenten in einem Lösemittel aufnehmen und die Lösung bzw. Dispersion durch Giessen, Sprühen, Tauchen oder Antragen mit Walzen auf den vorgesehenen Träger als Film aufbringen und anschliessend trocknen. Die Reproduktionsschichten werden in bekannter Weise belichtet und entwickelt. Als Entwickler sind wässrige, vorzugsweise wässrig-alkalische Lösungen, z.B. von Alkaliphosphaten oder Alkalisilikaten, geeignet, denen gegebenenfalls kleine Mengen an mischbaren organischen Lösemitteln und Netzmitteln zugesetzt werden können.

Die erfindungsgemässen Reproduktionsschichten eignen sich besonders in Form eines vorsensibilisierten Kopiermaterials auf einem geeigneten Träger, z.B. aus Aluminium, Polyester oder Zink, für die photomechanische Herstellung von Offsetdruckformen für den wasserlosen Offsetdruck. Das Trägermaterial aus z.B. Aluminium kann auch durch mechanische, chemische und/ oder elektrochemische Aufrauhung und gegebenenfalls einer nachfolgenden anodischen Oxidation an der Oberfläche modifiziert werden.

In den nachfolgenden Beispielen und im vorstehenden Text verhalten sich Gew.-Teile zu Vol.-Teilen wie g zu $cm^3$ und %-Angaben sind – wenn nichts anderes angegeben ist – auf das Gewicht bezogen.

Allgemeine Arbeitsvorschrift (Beispiele 1 bis 15 und 21) für die Acylierung von Hydroxyacrylaten 0,1 Äquivalente des Hydroxyacrylats (bezogen auf den OH-Gruppengehalt) und 0,1 Mol des Perfluoralkylgruppen enthaltenden Säurechlorids werden in 200 Vol.-Teilen Methylenchlorid gelöst. Dazu werden unter Rühren und Eiskühlung 0,1 Mol Triethylamin, gelöst in 50 Vol.-Teilen Methylenchlorid, innerhalb von 30 min zugetropft. Die Temperatur im Reaktionsgefäss wird dabei unter 20°C gehalten. Nach fünfstündiger Nachreaktion bei Raumtemperatur wird die flüssige Phase vom ausgefallenen Triethylammoniumhydrochlorid abfiltriert, mit Wasser chloridfrei gewaschen und mit $MgSO_4$ getrocknet. Nach dem erneuten Abfiltrieren werden 0,06 Gew.-Teile 4-Methoxyphenol als Polymerisationsinhibitor zugegeben, und das Methylenchlorid wird im Vakuum abdestilliert (z.B. im Rotationsverdampfer). Nach der Ausbeutebestimmung wird vom jeweiligen Reaktionsprodukt eine 20%ige Lösung in Butanon-2 für die später beschriebenen Anwendungsbeispiele bereitet.

In den Beispielen 4 und 5 wird als Edukt ein technisches Gemisch aus Pentaerythrittri- und -tetraacrylat eingesetzt. Da das Tetraacrylat keine substituierbare OH-Gruppe enthält, liegt der Fluorgehalt im Reaktionsprodukt niedriger als bei Einsatz des reinen Triacrylats. Wenn das als weiteres Edukt verwendete Säurechlorid neben den $CF_2$-Gruppen noch $CH_2$-Gruppen enthält, so kann bei der Umsetzung mit dem Acrylat, insbesondere bei Anwesenheit eines Überschusses an zugesetztem Amin, eine intramolekulare HF-Abspaltung stattfinden, die dann zu einer Doppelbindung führen kann. Im $^{19}F$-NMR-Spektrum ist dann ein Verschwinden eines $CF_2$-Signals und ein Auftreten eines neuen Signals geringerer Intensität zu beobachten.

Umsetzung von Carbonsäuren mit Epoxiden (Beispiel 16)

In einem mit Rührer, Thermometer, Kühler und Trockenrohr ausgestatteten Mehrhalskolben werden 0,2 Mol Glycidylmethacrylat und 0,1 Mol Dicarbonsäure durch Rühren vermischt und nach Zugabe von 0,3 Gew.-Teilen Hydrochinon als Polymerisationsinhibitor und 0,5 Gew.-Teilen Benzyltriethylammoniumchlorid vorsichtig auf eine Innentemperatur von etwa 80°C erhitzt. Nach einer Behandlungszeit von etwa 2 h wird eine klare Lösung erhalten, die mit Butanon-2 auf einen Feststoffgehalt von 20% verdünnt wird.

Umsetzung mit Isocyanaten (Beispiele 17 bis 20)

In einem mit Rührer, Thermometer, Kühler und Trockenrohr ausgestatteten Mehrhalskolben werden 0,1 Äquivalente eines Isocyanats oder Diisocyanats mit 0,1 Äquivalenten einer Hydroxylgruppen enthaltenden Perfluorverbindung in 400 Vol.-Teilen Butanon-2 in Gegenwart von 0,2 Gew.-Teilen Dibutylzinndilaurat unter Stickstoff während 3 h auf 78°C erhitzt. Nach dem Abkühlen wird das Reaktionsgemisch in Eiswasser gegeben, der ausgefällte Feststoff abfiltriert und getrocknet. Die Butanon-2-Lösung kann auch direkt in Anwendungsbeispielen eingesetzt werden.

Die Edukte und Produkte der Beispiele 1 bis 21 werden in der nachfolgenden Tabelle näher charakterisiert, die Produkte der Beispiele 1 bis 16 und 19 bis 21 werden dabei als Monomere und die der Beispiele 17 und 18 als Oligomere angesehen.

Tabelle I

| Beispiel | Edukte | Produkt (Strukturformel, Summenformel, Molekularmasse) | Ausbeute (%) | Fluorgehalt im Produkt ber. | Fluorgehalt im Produkt gef. |
|---|---|---|---|---|---|
| 1 | 1.1 Pentaerythrittriacrylat<br>$(HO{\cdot}CH_2-C(CH_2OOCCH=CH_2)_3$ | 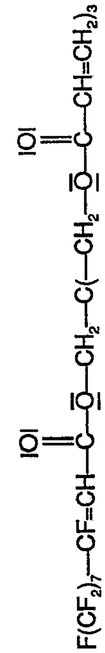<br>$C_{24}H_{18}O_8F_{16}$ (738) | 63 | 41,2 | 38,6 |
| | 1.2 2,2-Dihydro-perfluordecansäurechlorid<br>$F(CF_2)_8-CH_2-COCl$ | | | | |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 2 | 2.1 wie 1.1<br>2.2 Mischung von 2,2-Dihydro-perfluor-octansäurechlorid bis 2,2-Dihydro-perfluor-tetradecan-säurechlorid $F(CF_2)_{6,5}-CH_2-COCl$ | 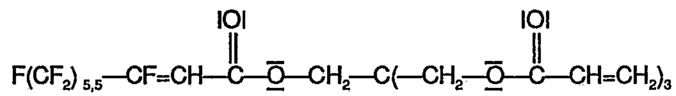<br>$C_{22,5}H_{18}O_8F_{13}$ (663) | 87 | 37,3 | 36,7 |
| 3 | 3.1 wie 1.1<br>3.2 Mischung von Buten(2)-di-säure-monochlorid-mono-1′,1′,2′,2′-tetrahydro-perfluor-octylester bis Buten(2)-disäure-monochlorid-mono-1′,1′,2′,2′tetrahydroperfluor-tetradecylester<br>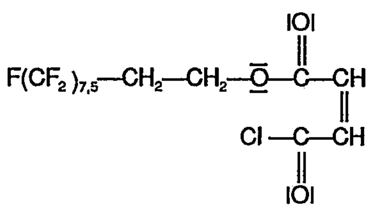 | 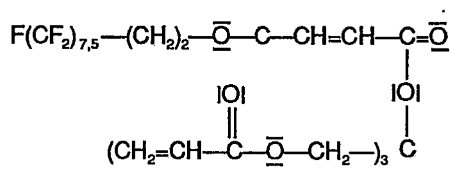<br>$C_{27,5}H_{23}O_{10}F_{16}$ (817) | 83 | 37,2 | 36,5 |
| 4 | 4.1 Mischung aus Pentaerythrit-triacrylat und -tetraacrylat<br>4.2 2,2-Dihydro-perfluor-octan-säurechlorid<br>$F(CF_2)_6-CH_2-COCl$ | 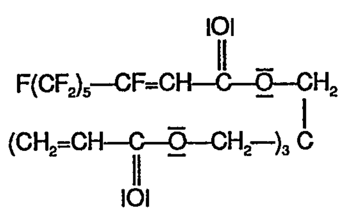<br>$C_{22}H_{18}O_8F_{12}$ (638) | 65 | 35,7 | 21,3 |

Tabelle I (Fortsetzung)

| Beispiel | Edukte | Produkt (Strukturformel, Summenformel, Molekularmasse) | Ausbeute (%) | Fluorgehalt im Produkt ber. | Fluorgehalt im Produkt gef. |
|---|---|---|---|---|---|
| 5 | 5.1 wie 4.1<br>5.2 Perfluor-octansäurechlorid $F(CF_2)_7-COCl$ | 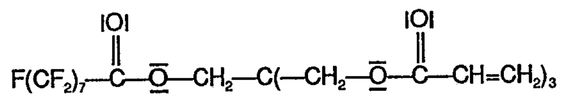<br>$C_{22}H_{17}O_8F_{15}$ (694) | 77 | 41,1 | 35,5 |
| 6 | 6.1 Glycerindimethacrylat<br>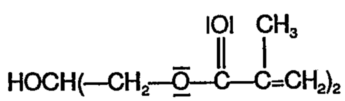<br>6.2 wie 2.2 | 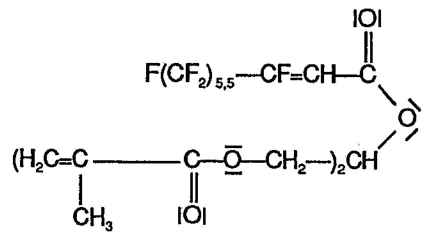<br>$C_{19,5}H_{16}O_6F_{13}$ (593) | 97 | 41,7 | 41,7 |
| 7 | 7.1 wie 6.1<br>7.2 wie 1.2 | 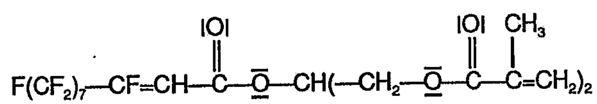<br>$C_{21}H_{16}O_6F_{16}$ (668) | 77 | 44,2 | 44,9 |
| 8 | 8.1 wie 6.1<br>8.2 wie 5.2 | 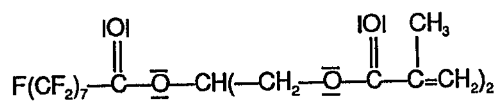<br>$C_{19}H_{16}O_6F_{15}$ (624) | 77 | 45,7 | 42,7 |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 9 | 9.1 Umsetzungsprodukt aus Adipinsäure (Hexandisäure) und Glycidylmethacrylat 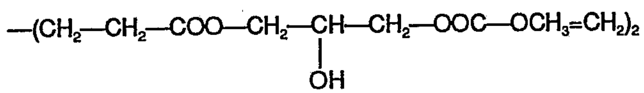 9.2 wie 5.2 | 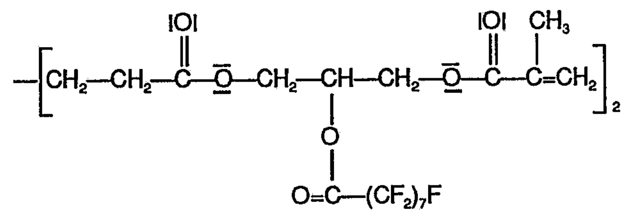 $C_{36}H_{28}O_{12}F_{30}$ (1222) | - | 46,6 | 48,2 |
| 10 | 10.1 wie 9.1 10.2 wie 1.2 | 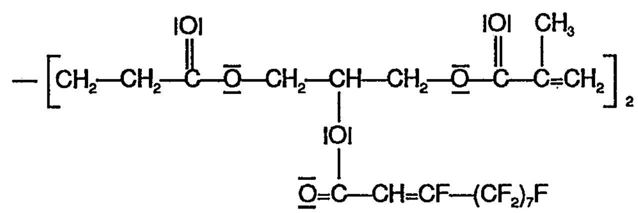 $C_{40}H_{30}O_{12}F_{32}$ (1310) | - | 46,4 | 49,8 |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 11 | 11.1 Umsetzungsprodukt aus Bisphenol A und Glycidyl-methacrylat 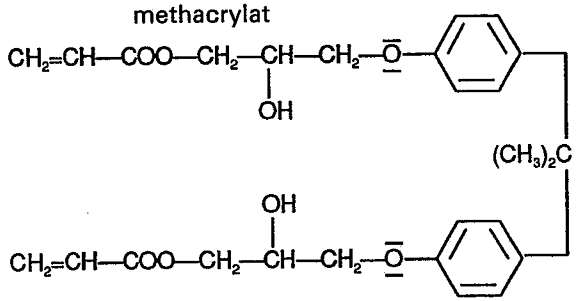 11.2 wie 5.2 | 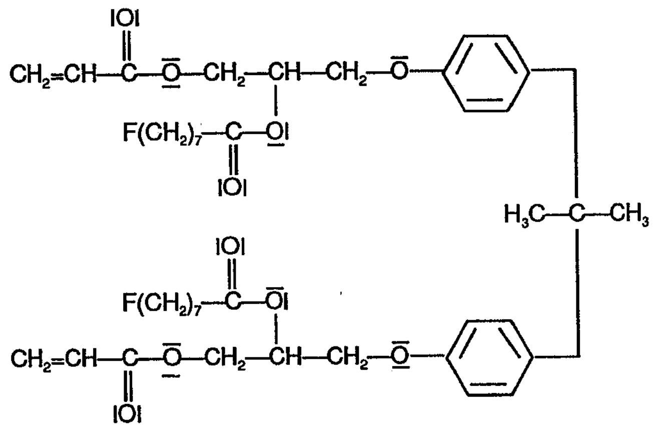 $C_{45}H_{34}O_{10}F_{30}$ (1304) | - | 43,7 | 47,9 |
| 12 | 12.1 wie 11.1 12.2 wie 1.2 | 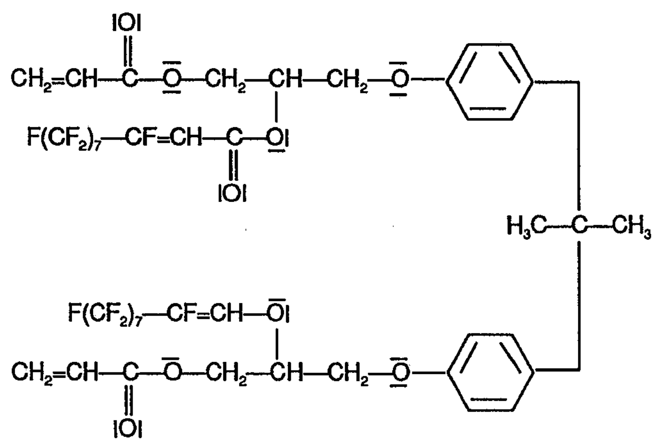 $C_{49}H_{36}O_{10}F_{32}$ (1392) | - | 43,7 | 47,1 |

Tabelle I (Fortsetzung)

| Beispiel | Edukte | Produkt (Strukturformel, Summenformel, Molekularmasse) | Ausbeute (%) | Fluorgehalt im Produkt ber. | Fluorgehalt im Produkt gef. |
|---|---|---|---|---|---|
| 13 | 13.1 Umsetzungsprodukt aus einem Perfluoralkanol, Epichlorhydrin und Benzoltetracarbonsäureanhydrid 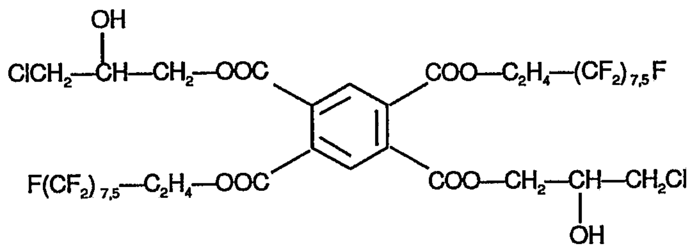 13.2 Methacrylsäurechlorid 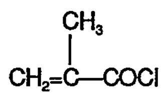 | 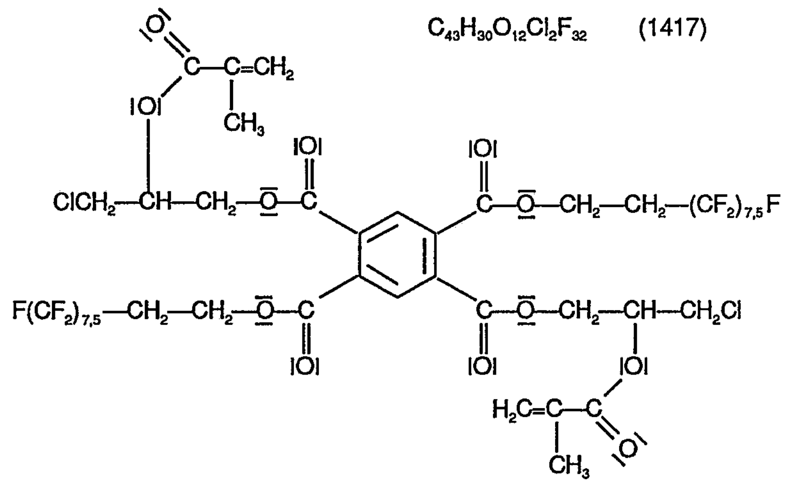 $C_{43}H_{30}O_{12}Cl_2F_{32}$ (1417) | 60 | 42,9 | 43,2 |
| 14 | 14.1 Umsetzungsprodukt aus einem Perfluoralkanol, Epichlorhydrin und Benzophenontetracarbonsäureanhydrid<br>14.2 wie 13.2 | 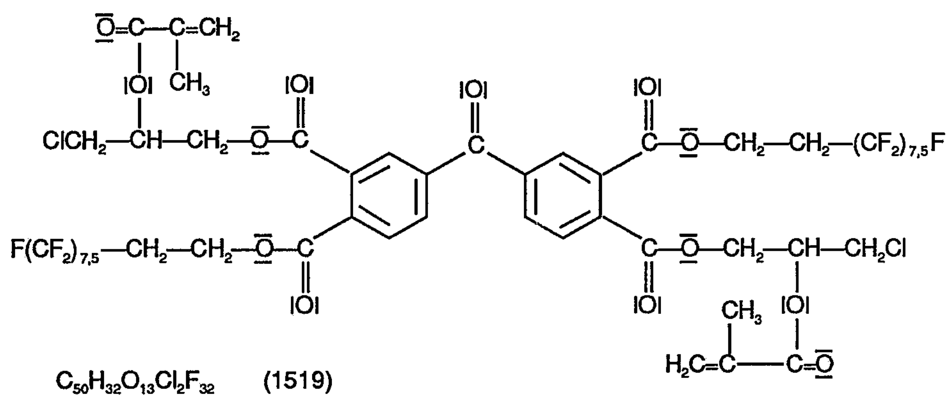 $C_{50}H_{32}O_{13}Cl_2F_{32}$ (1519) | 83,1 | 40,0 | 38,9 |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 15 | 15.1 Umsetzungsprodukt aus einem Perfluoralkanol, Pentaerythrit und Buten-2-disäureanhydrid 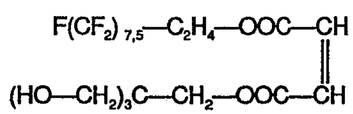 15.2 wie 13.2 | 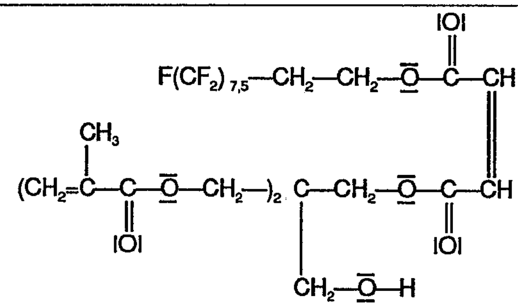 $C_{26,5}H_{25}O_9F_{16}$ (791) | 76 | 38,4 | 38,2 |
| 16 | 16.1 Umsetzungsprodukt aus einem Perfluoralkanol und Benzophenontetracarbonsäureanhydrid 16.2 Methacrylsäureester des 1,2-Epoxy-propanols-3 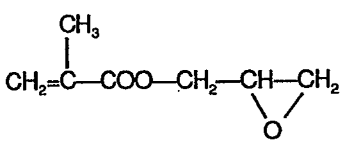 | 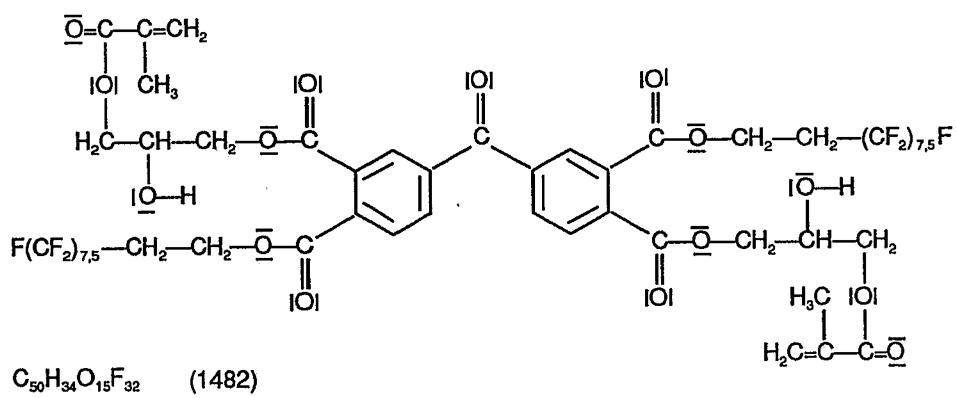 $C_{50}H_{34}O_{15}F_{32}$ (1482) | - | 41,0 | 36,0 |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 17 | 17.1 Produkt Beispiel 16<br>17.2 Hexan-1,6-diisocyanat<br>$OCN-(CH_2)_6-NCO$ | 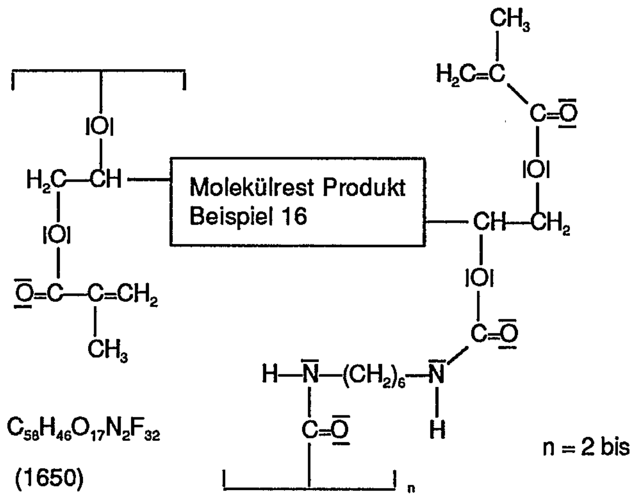<br>$C_{58}H_{46}O_{17}N_2F_{32}$<br>(1650)<br>n = 2 bis 5 | – | 36,8 | 28,6 |
| 18 | 18.1 Produkt Beispiel 16<br>18.2 Toluol-1,3-diisocyanat<br>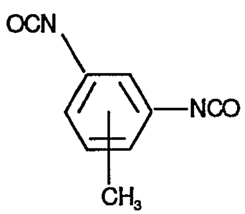 | 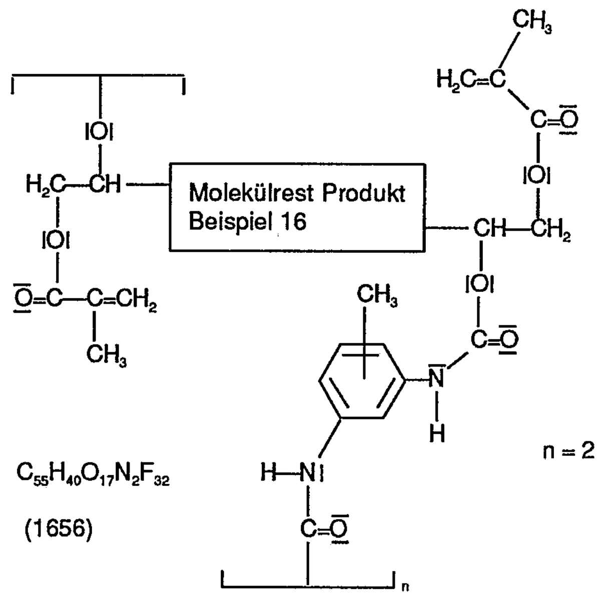<br>$C_{55}H_{40}O_{17}N_2F_{32}$<br>(1656)<br>n = 2 bis 5 | – | 36,7 | 29,6 |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 19 | 19.1 Produkt Beispiel 16<br>19.2 Isocyanato-ethylmeth-acrylat<br>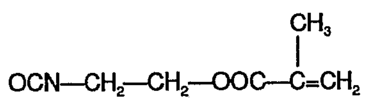 | 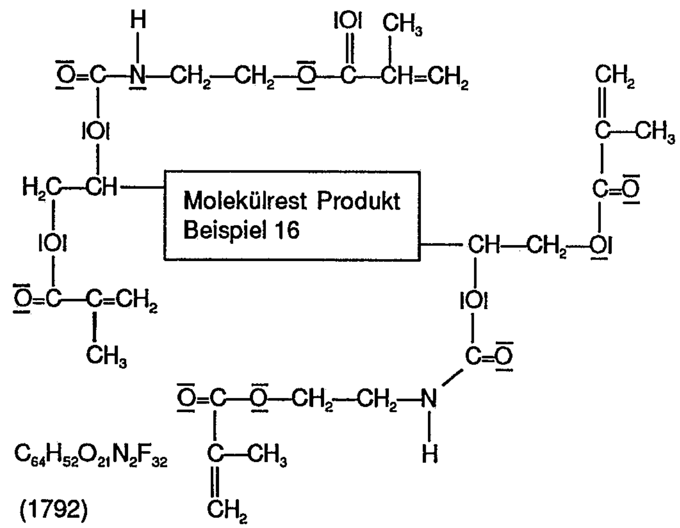<br>$C_{64}H_{52}O_{21}N_2F_{32}$<br>(1792) | – | 33,9 | 28,7 |
| 20 | 20.1 Edukt wie 15.1<br>20.2 wie 19.2 | 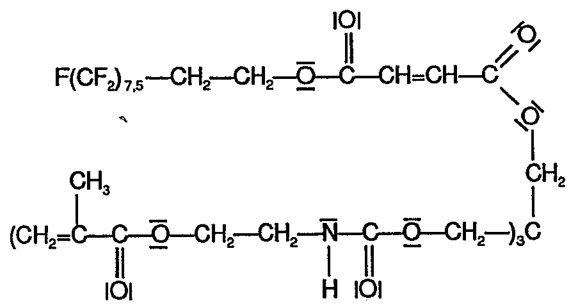<br>$C_{39,5}H_{44}O_6N_3F_{16}$ (1120) | 83 | 27,1 | 27,5 |

Tabelle I (Fortsetzung)

| Beispiel | Edukte | Produkt (Strukturformel, Summenformel, Molekularmasse) | Ausbeute (%) | Fluorgehalt im Produkt ber. | gef. |
|---|---|---|---|---|---|
| 21 | 21.1 Glycerindiacrylat 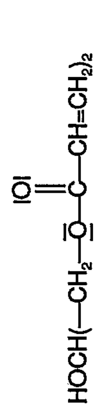 21.2 wie 5.2 | 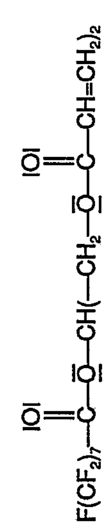 $C_{17}H_{12}O_6F_{15}$ (596) | 80 | 47,8 | 43,4 |

Anwendungsbeispiele (Beispiele 22 bis 47)

Die in den Beispielen 1 bis 21 synthetisierten Produkte können als polymerisierbare Mono- bzw. Oligomere im Gemisch mit einem Photoinitiator, einem Farbstoff und einem polymeren organischen Bindemittel und gegebenenfalls mit einem weiteren polymerisierbaren Monomeren bzw. Oligomeren zu einer Reproduktionsschicht verarbeitet werden. Dazu wird im Regelfall eine Lösung oder Dispersion der Komponenten in einem organischen Lösemittel (Butanon-2 oder 1-Methoxy-Propanol-2) hergestellt und auf ein Trägermaterial wie eine elektrochemisch aufgerauhte Aluminiumfolie oder eine Polyesterfolie aufgebracht. Anschliessend wird die strahlungsempfindliche Beschichtung getrocknet. Zur Verhinderung der Sauerstoffdiffusion wird auf die Reproduktionsschicht eine Deckschicht aus Polyvinylalkohol aufgebracht.

Die so vorbereiteten Offsetdruckplatten werden mit einer Metallhalogenidlampe (5 kW) im Abstand von 100 cm zwischen Lampe und Vakuumkopierrahmen durch eine Positivvorlage hindurch während 20 bis 150 sec belichtet. Die Entwicklung des belichteten Materials kann meist mit einer 3%igen wässrigen $Na_2SiO_3$-Lösung (E1) durchgeführt werden, die in den mit E2 gekennzeichneten Beispielen noch Glyzerin, Propylenglykol und Ethylenglykolmonoacetat enthält. Nach Abwaschen mit Wasser und einer kurzen Trocknung bei 100°C kann mit den so hergestellten Druckformen trocken (d.h. unter Abschalten des Feuchtwerks einer Druckmaschine) mit käuflichen Spezialfarben für den wasserlosen Offsetdruck gedruckt werden. Die farbannehmenden Stellen sind Teile der Oberfläche des Trägermaterials, die farbabstossenden Stellen die stehengebliebenen Teile der Reproduktionsschicht.

Als Photoinitiator wird in allen Beispielen 2-(4-Ethoxy-naphth-1-yl)-4,6-bis-trichlormethyl-s-triazin eingesetzt, als Bindemittel eines der in der Beschreibung genannten in der DE-A 3 421 526 (EP-A 167 777) erstmals beschriebenen Perfluoralkylgruppen enthaltenden Polymeren, diese sind Copolymerisate aus den Komponenten Acrylsäureester des $F(CF_2)_{7,5}$-$CH_2$-$CH_2$-O-H (Komp. I) und Methacrylsäureester/m-Hydroxybenzoesäureester des Glycerins (Komp. II) als B1 (60/40 von Komp. I/Komp. II), B2 (40/60) und B3 (30/70). Im Bindemittel B4 (60/40) ist die erste Komponente der Acrylsäureester des 1,1,2,2-Tetrahydro-perfluordecanols-1 und im Bindemittel B5 (60/40) der Vinyl-benzylether des 1,1,2,2-Tetrahydroperfluordecanols-1.

Als Beurteilungskriterien für die Reproduktionsschicht dienen die Beschichtungsqualität (G = gut, B = befriedigend, M = mässig) durch visuelle Beurteilung vor der Bestrahlung, Entwicklung und Einfärbung und nach diesen Verfahrensstufen die Anzahl der freien bzw. gedeckten Stufen in einem Halbtonstufenkeil mit 13 Stufen einer Keilkonstante (Dichteabstufung) von 0,15 (z.B. Belichtungstestkeil «BKO1» der Firma Kalle, Niederlassung der Hoechst AG) und die Wiedergabe von feinsten Bildelementen in einem 12stufigen Rasterkeil mit 60er Raster, beginnend mit einem Tonwert von 5% in Stufe 1 und endend mit einem Tonwert von 95% in Stufe 12 (z.B. Rasterkeil «RKO1» der Firma Kalle, Niederlassung der Hoechst AG); bei der Anwendung des Rasterkeils sind einerseits in der Tabelle die Anzahl der Felder angegeben, die noch Farbe abstossen (v) (d.h. Nichtbildstellen aufweisen) und andererseits das Feld, das erstmals Farbe annimmt (w).

Tabelle II

| Komponenten, Behandlungsmittel, Beurteilung | | Gew.-Teile der Komponenten (bzw. andere Parameter) im Beispiel | | | | | | | |
|---|---|---|---|---|---|---|---|---|---|
| | | 22 | 23 | 24 | 25 | 26 | 27 | 28 | 29 |
| Bindemittel | B1 | 1,0 | 1,0 | | | | | | |
| | B2 | | | | | 0,5 | | | |
| | B3 | | | 0,5 | 0,5 | | 1,0 | 0,5 | |
| | B4 | | | | | | | | 1,0 |
| | B5 | | | | | | | | |
| polymerisierbares Monomeres | Bsp. 1 | | | | | | | | 1,0 |
| | 2 | 0,5 | 0,5 | | | | | | |
| | 4 | | | | | | | | |
| | 5 | | | | | | | | |
| | 6 | | | | | | | | |
| | 7 | | | | | | | | |
| | 8 | | | | | | | | |
| | 9 | | | | | | | | |
| | 10 | | | | | | | | |
| | 13 | | | 1,0 | | | | | |
| | 14 | | | | 1,0 | | | | |
| | 15 | | | | | 1,0 | | | |
| | 16 | | | | | | 1,0 | 1,0 | |
| | 19 | | | | | | | | |
| | 20 | | | | | | | | |
| | 21 | | | | | | | | |
| polymerisierbares Oligomeres | Bsp. 17 | – | 0,25 | 0,5 | 0,5 | 0,5 | – | 0,5 | 0,5 |
| | 18 | – | – | – | – | – | – | – | – |
| Photoinitiator | | 0,025 | 0,025 | 0,05 | 0,05 | 0,05 | 0,05 | 0,05 | 0,05 |
| Farbstoff | | 0,025 | 0,025 | 0,025 | 0,025 | 0,025 | 0,025 | 0,025 | 0,02 |
| Butanon-2 | | 10 | 10 | 10 | 10 | 10 | 10 | 10 | 15 |
| 1-Methoxy-propanol-2 | | 4 | 4 | – | – | – | – | – | 4 |
| Beschichtungsqualität | | G | G | G | G | G | G | G | G |
| Belichtungszeit (sec) | | 100 | 50 | 150 | 70 | 150 | 150 | 150 | 50 |
| Entwickler | | E1 | E1 | E2 | E1 | E1 | E1 | E2 | E1 |
| Entwicklungszeit (min) | | 2 | 2 | 2 | 2 | 1 | 1 | 2 | 1,5 |
| Halbtonstufenkeil (x/y) *) | | 6/8 | 7/8 | 12/13 | 9/10 | 13 | 2/6 | 10/12 | 12/– |
| Rasterkeil (v/w) | | 11/2 | 12/3 | 12/3 | 12/4 | 12/10 | 11/2 | 12/3 | 12/4 |

*) x = Anzahl der vollgedeckten Stufen
y = Summe von vollgedeckten und teilgedeckten Stufen

Tabelle II (Fortsetzung)

| Komponenten, Behandlungsmittel, Beurteilung | | Gew.-Teile der Komponenten (bzw. andere Parameter) im Beispiel | | | | | | | |
|---|---|---|---|---|---|---|---|---|---|
| | | 30 | 31 | 32 | 33 | 34 | 35 | 36 | 37 |
| Bindemittel | B1 | | | | | | | | |
| | B2 | | | | | | | | |
| | B3 | | | | | | | | |
| | B4 | 1,0 | 1,0 | 1,0 | 1,0 | 1,0 | 1,0 | 1,0 | 1,0 |
| | B5 | | | | | | | | |

Tabelle II (Fortsetzung)

| Komponenten, Behandlungsmittel, Beurteilung | | Gew.-Teile der Komponenten (bzw. andere Parameter) im Beispiel | | | | | | | |
|---|---|---|---|---|---|---|---|---|---|
| | | 30 | 31 | 32 | 33 | 34 | 35 | 36 | 37 |
| polymerisierbares Monomeres | Bsp. 1 | | | | | | | | |
| | 2 | 1,0 | | | | | | | |
| | 4 | | | 1,0 | | | | | |
| | 5 | | | | 1,0 | | | | |
| | 6 | | | | | 1,0 | | | |
| | 7 | | | | | | 1,0 | | |
| | 8 | | | | | | | 1,0 | |
| | 9 | | | | | | | | |
| | 10 | | | | | | | | |
| | 13 | | | | | | | | |
| | 14 | | | | | | | | |
| | 15 | | | | | | | | |
| | 16 | | | | | | | | |
| | 19 | | | | | | | | 1,0 |
| | 20 | | | | | | | | |
| | 21 | | 1,0 | | | | | | |
| polymerisierbares Oligomeres | Bsp. 17 | 0,5 | 0,5 | 0,5 | 0,5 | 0,5 | 0,5 | 0,5 | 0,5 |
| | 18 | – | – | – | – | – | – | – | – |
| Photoinitiator | | 0,05 | 0,05 | 0,05 | 0,05 | 0,05 | 0,05 | 0,05 | 0,05 |
| Farbstoff | | 0,02 | 0,02 | 0,02 | 0,02 | 0,02 | 0,02 | 0,02 | 0,02 |
| Butanon-2 | | 15 | 15 | 15 | 15 | 15 | 15 | 15 | 15 |
| 1-Methoxy-propanol-2 | | – | 4 | 4 | 4 | 4 | 4 | 4 | 4 |
| Beschichtungsqualität | | G | G | G | B | G | M | G | G |
| Belichtungszeit (sec) | | 50 | 50 | 50 | 50 | 50 | 50 | 50 | 50 |
| Entwickler | | E1 | E1 | E1 | E1 | E1 | E1 | E1 | E1 |
| Entwicklungszeit (min) | | 1,5 | 0,5 | 1,0 | 0,75 | 1,0 | 1,0 | 0,5 | 1,0 |
| Halbtonstufenkeil (x/y) | | 9/11 | 5/9 | 3/5 | 4/6 | 7/10 | 6/9 | 4/7 | 10/– |
| Rasterkeil (v/w) | | 12/3 | 9/2 | 11/2 | 12/1 | 11/3 | 11/3 | 8/2 | 12/2 |

Tabelle II (Fortsetzung)

| Komponenten, Behandlungsmittel, Beurteilung | | Gew.-Teile der Komponenten (bzw. andere Parameter) im Beispiel | | | | | | |
|---|---|---|---|---|---|---|---|---|
| | | 38 | 39 | 40 | 41 | 42 | 43 | 44 |
| Bindemittel | B1 | | | | | | 1,0 | 1,0 |
| | B2 | | | | | | | |
| | B3 | | | | | | | |
| | B4 | 1,0 | 1,0 | 1,0 | | | | |
| | B5 | | | | 1,0 | 1,0 | | |
| polymerisierbares Monomeres | Bsp. 1 | | 1,0 | 1,0 | 1,0 | 1,0 | | |
| | 2 | | | | | | | |
| | 4 | | | | | | | |
| | 5 | | | | | | 1,0 | 1,0 |
| | 6 | | | | | | | |
| | 7 | | | | | | | |
| | 8 | | | | | | | |
| | 9 | | | | | | | |
| | 10 | | | | | | | |
| | 13 | | | | | | | |
| | 14 | | | | | | | |
| | 15 | | | | | | | |
| | 16 | | | | | | | |
| | 19 | | | | | | | |
| | 20 | 1,0 | | | | | | |
| | 21 | | | | | | | |

Tabelle II (Fortsetzung)

| Komponenten, Behandlungsmittel, Beurteilung | | Gew.-Teile der Komponenten (bzw. andere Parameter) im Beispiel | | | | | | |
|---|---|---|---|---|---|---|---|---|
| | | 38 | 39 | 40 | 41 | 42 | 43 | 44 |
| polymerisierbares Oligomeres | Bsp. 17 | 0,5 | 0,5 | – | 0,5 | – | 0,5 | – |
| | 18 | – | – | 0,5 | – | 0,5 | – | 0,5 |
| Photoinitiator | | 0,05 | 0,05 | 0,05 | 0,05 | 0,05 | 0,05 | 0,05 |
| Farbstoff | | 0,02 | 0,02 | 0,02 | 0,02 | 0,02 | 0,02 | 0,02 |
| Butanon-2 | | 15 | 15 | 15 | 15 | 15 | 15 | 15 |
| 1-Methoxy-propanol-2 | | 4 | – | – | – | – | 4 | 4 |
| Beschichtungsqualität | | G | M | M | B | B | G | G |
| Belichtungszeit (sec) | | 50 | 20 | 20 | 20 | 20 | 50 | 50 |
| Entwickler | | E1 | E1 | E1 | E1 | E1 | E1 | E1 |
| Entwicklungszeit (min) | | 1,0 | 1,0 | 1,0 | 1,0 | 1,0 | 0,5 | 0,5 |
| Halbtonstufenkeil (x/y) | | 9/10 | 11/12 | 11/12 | 11/12 | 11/12 | 3/5 | 5/7 |
| Rasterkeil (v/w) | | 11/2 | 12/3 | 12/4 | 12/4 | 11/3 | 12/1 | 12/1 |

Tabelle II (Fortsetzung)

| Komponenten, Behandlungsmittel, Beurteilung | | Gew.-Teile der Komponenten (bzw. andere Parameter) im Beispiel | | |
|---|---|---|---|---|
| | | 45 | 46 | 47 |
| Bindemittel | B1 | | | |
| | B2 | | | |
| | B3 | | | |
| | B4 | 1,0 | 1,0 | 1,0 |
| | B5 | | | |
| polymerisierbares Monomeres | Bsp. 1 | | | |
| | 2 | | | |
| | 4 | | | |
| | 5 | | | |
| | 6 | | | |
| | 7 | | | |
| | 8 | | | |
| | 9 | 1,0 | | |
| | 10 | | 1,0 | |
| | 13 | | | |
| | 14 | | | |
| | 15 | | | |
| | 16 | | | |
| | 19 | | | |
| | 20 | | | |
| | 21 | | | 1,0 |
| polymerisierbares Oligomeres | Bsp. 17 | – | – | – |
| | 18 | – | – | – |
| Photoinitiator | | 0,05 | 0,05 | 0,05 |
| Farbstoff | | 0,02 | 0,02 | 0,02 |
| Butanon-2 | | 15 | 15 | 15 |
| 1-Methoxy-propanol-2 | | 4 | 4 | 4 |
| Beschichtungsqualität | | G | G | M |
| Belichtungszeit (sec) | | 50 | 50 | 50 |
| Entwickler | | E1 | E1 | E1 |
| Entwicklungszeit (min) | | 0,5 | 1,25 | 1,5 |
| Halbtonstufenkeil (x/y) | | 4/8 | 12/– | 7/13 |
| Rasterkeil (v/w) | | 12/2 | 12/4 | 11/2 |

## Patentansprüche

1. Polymerisierbare, Perfluoralkylgruppen aufweisende Verbindungen mit mindestens zwei endständigen ethylenisch-ungesättigten Gruppen, dadurch gekennzeichnet, dass sie mindestens zwei Acryloyl- oder Methacryloylgruppen und mindestens eine über eine mindestens ein Heteroatom enthaltende funktionelle Gruppe, die nicht unmittelbar der Acryloyl- bzw. Methacryloylgruppe benachbart ist und ursprünglich zum in das Molekül eingeführten Perfluoralkylrest gehörte, an das Molekül gebundene Perfluoralkylgruppe aufweisen.

2. Verbindungen nach Anspruch 1, dadurch gekennzeichnet, dass sie mindestens eine über eine Ester- oder Amidfunktion an das Molekül gebundene Perfluoralkylgruppe aufweisen.

3. Verbindung nach einem der Ansprüche 1 oder 2, dadurch gekennzeichnet, dass die Perfluoralkylgruppe über ein Alkylenzwischenglied mit 1 bis 5 C-Atomen mit der funktionellen Gruppe verbunden ist.

4. Verbindungen nach einem der Ansprüche 1 bis 3, dadurch gekennzeichnet, dass sie mindestens drei Acryloyloxy- oder Methacryloyloxygruppen und mindestens eine über eine Esterfunktion an das Molekül gebundene Perfluoralkylgruppe aufweisen.

5. Verfahren zur Herstellung der Verbindungen nach einem der Ansprüche 1 bis 4, dadurch gekennzeichnet, dass eine mindestens zwei Acryloyl- oder Methacryloylgruppen und mindestens eine Hydroxylgruppe aufweisende Komponente mit einem eine Perfluoralkylgruppe aufweisenden Carbonsäurechlorid in Gegenwart eines Amins umgesetzt wird.

6. Strahlungsempfindliche Reproduktionsschicht mit einem Gehalt an a) mindestens einer polymerisierbaren, Perfluoralkylgruppen aufweisenden Verbindung mit mindestens zwei endständigen, ethylenisch-ungesättigten Gruppen und b) mindestens einem Photoinitiator, dadurch gekennzeichnet, dass die Verbindung a) mindestens zwei Acryloyl- oder Methacryloylgruppen und mindestens eine über eine mindestens ein Heteroatom enthaltende funktionelle Gruppe, die nicht unmittelbar der Acryloyl- bzw. Methacryloylgruppe benachbart ist und ursprünglich zum in das Molekül eingeführten Perfluoralkylrest gehörte, an das Molekül gebundene Perfluoralkylgruppe aufweist und die Reproduktionsschicht gegebenenfalls c) mindestens ein organisches polymeres Bindemittel enthält.

7. Reproduktionsschicht nach Anspruch 6, dadurch gekennzeichnet, dass sie ein Perfluoralkylgruppen enthaltendes Bindemittel enthält.

8. Reproduktionsschicht nach Anspruch 6 oder 7, dadurch gekennzeichnet, dass sie ein in wässrig-alkalischen Lösungen lösliches Bindemittel enthält.

9. Reproduktionsschicht nach einem der Ansprüche 6 bis 8, dadurch gekennzeichnet, dass sie als Komponente (d) mindestens eine weitere von der Komponente (a) verschiedene perfluoralkylgruppenfreie polymerisierbare Verbindung enthält.

10. Reproduktionsschicht nach einem der Ansprüche 6 bis 9, dadurch gekennzeichnet, dass sie 20 bis 80% an polymerisierbaren Verbindungen und 80 bis 20% an organischen polymeren Bindemitteln enthält.

11. Reproduktionsschicht nach einem der Ansprüche 6 bis 10, dadurch gekennzeichnet, dass sie als Komponente (a) ein Gemisch aus einer monomeren mindestens zwei Acryloyl- oder Methacryloylgruppen und mindestens eine über eine funktionelle Gruppe an das Molekül gebundene Perfluoralkylgruppe aufweisenden Verbindung und einem Oligomeren enthält, das aus mindestens zwei dieser Monomeren durch Umsetzung mit einem mindestens bifunktionell reagierenden Zwischenglied synthetisiert wurde.

12. Verwendung einer Reproduktionsschicht nach den Ansprüchen 6 bis 11 als strahlungsempfindliche Beschichtung von Druckplattenträgermaterialien für den wasserlosen Offsetdruck.

## Claims

1. Polymerizable compounds comprising perfluoroalkyl groups and having at least two ethylenically unsaturated end groups, characterized in that they contain at least two acryloyl or methacryloyl groups and at least one perfluoroalkyl group which is linked to the molecule through a functional group comprising at least one hetero atom, which functional group is not immediately adjacent to the acryloyl or methacryloyl groups, respectively, and which was initially part of the perfluoroalkyl group when introduced into the molecule.

2. Compounds as claimed in claim 1, which have at least one perfluoroalkyl group which is linked to the molecule through an ester or amide function.

3. Compounds as claimed in claim 1 or claim 2, wherein the perfluoroalkyl group is linked to the functional group through an alkylene intermediate member having from 1 to 5 carbon atoms.

4. Compounds as claimed in any of claims 1 to 3, which have at least three acryloyloxy or methacryloyloxy groups and at least one perfluoroalkyl group which is linked to the molecule through an ester function.

5. Process for the preparation of the compounds as claimed in any of claims 1 to 4, wherein a component having at least two acryloyl or methacryloyl groups and at least one hydroxyl group is reacted with a carboxylic acid chloride containing a perfluoroalkyl group, in the presence of an amine.

6. Radiation-sensitive reproduction layer containing a) at least one polymerizable compound comprising perfluoroalkyl groups and having at least two ethylenically unsaturated end groups and b) at least one photoinitiator, wherein the compound a) has at least two acryloyl or methacryloyl groups and at least one perfluoroalkyl group which is linked to the molecule through a

functional group comprising at least one hetero atom, which functional group is not immediately adjacent to the acryloyl or methacryloyl groups, respectively, and which was initially part of the perfluoroalkyl group when introduced into the molecule, and the reproduction layer optionally contains c) at least one organic polymeric binder.

7. A reproduction layer as claimed in claim 6, which contains a binder comprising perfluoroalkyl groups.

8. A reproduction layer as claimed in claim 6 or claim 7, which contains a binder which is soluble in aqueousalkaline solutions.

9. A reproduction layer as claimed in any of claims 6 to 8, which contains as component (d) at least one additional polymerizable compound which is different from component (a) and is free from perfluoroalkyl groups.

10. A reproduction layer as claimed in any of claims 6 to 9, which contains form 20 to 80% of polymerizable compounds and from 80 to 20% of organic polymeric binders.

11. A reproduction layer as claimed in any of claims 6 to 10, which comprises a component (a) a mixture of a monomeric compound having at least two acryloyl or methacryloyl groups and at least one perfluoroalkyl group which is linked to the molecule through a functional group and an oligomer synthesized from at least two of these monomers by reaction with an at least bifunctionally reacting intermediate member.

12. Use of a reproduction layer as claimed in claims 6 to 11, as a radiation-sensitive coating of support materials for printing plates for use in waterless offset printing.

**Revendications**

1. Composés polymérisables comportant des groupes perfluoroalkyle et au moins deux groupes terminaux à insaturation éthylénique, caractérisés en ce qu'ils comportent au moins deux groupes acryloyle ou méthacryloyle et au moins un groupe perfluoroalkyle lié à la molécule par un groupe fonctionnel contenant au moins un hétéroatome, lequel groupe fonctionnel n'est pas immédiatement voisin du groupe acryloyle ou méthacryloyle et appartenait initialement au reste perfluoroalkyle introduit dans la molécule.

2. Composés selon la revendication 1, caractérisés en ce qu'ils comportent au moins un groupe perfluoroalkyle lié à la molécule par une fonction ester ou amide.

3. Composés selon l'une des revendications 1 ou 2, caractérisés en ce que le groupe perfluoroalkyle est lié au groupe fonctionnel par un chaînon intermédiaire alkylène ayant de 1 à 5 atomes de carbone.

4. Composés selon l'une des revendications 1 à 3, caractérisés en ce qu'ils comportent au moins 3 groupes acryloyloxy ou méthacryloxy et au moins un groupe perfluoroalkyle lié à la molécule par une fonction ester.

5. Procédé pour la préparation des composés selon l'une des revendications 1 à 4, caractérisés en ce que l'on fait réagir un composant comportant au moins deux groupes acryloyle ou méthacryloyle et au moins un groupe hydroxy, avec un chlorure d'acide carboxylique comportant un groupe perfluoroalkyle, en présence d'une amine.

6. Couche de reproduction sensible aux radiations, ayant une teneur en a) au moins un composé polymérisable comportant des groupes perfluoroalkyle et au moins deux groupes terminaux à insaturation éthylénique, et b) au moins un photoinitiateur, caractérisée en ce que le composé (a) comporte au moins deux groupes acryloyle ou méthacryloyle et au moins un groupe perfluoroalkyle lié à la molécule par un groupe fonctionnel contenant au moins un hétéroatome, groupe fonctionnel qui n'est pas immédiatement voisin du groupe acryloyle ou méthacryloyle et appartenait initialement au reste perfluoroalkyle introduit dans la molécule, et la couche de reproduction contient éventuellement c) au moins un liant organique polymère.

7. Couche de reproduction selon la revendication 6, caractérisée en ce qu'elle contient un liant comportant des groupes perfluoroalkyle.

8. Couche de reproduction selon la revendication 6 ou 7, caractérisée en ce qu'elle contient un liant soluble dans des solutions aqueuses alcalines.

9. Couche de reproduction selon l'une des revendications 6 à 8, caractérisée en ce qu'elle contient en tant que composant (d) au moins un autre composé polymérisable différent du composant (a), exempt de groupes perfluoroalkyle.

10. Couche de reproduction selon l'une des revendications 6 à 9, caractérisée en ce qu'elle contient de 20 à 80% de composés polymérisables et de 80 à 20% de liants organiques polymères.

11. Couche de reproduction selon l'une des revendications 6 à 10, caractérisée en ce qu'elle contient en tant que composant (a) un mélange d'un composé monomère comportant au moins deux groupes acryloyle ou méthacryloyle et au moins un groupe perfluoroalkyle lié à la molécule par un groupe fonctionnel, et un oligomère qui a été synthétisé à partir d'au moins deux de ces monomères, par réaction avec un chaînon intermédiaire à réaction au moins bifonctionnelle.

12. Utilisation d'une couche de reproduction selon les revendications 6 à 11, en tant que revêtement, sensible aux radiations, de matériaux de support pour plaques d'impression destinés à l'impression offset à sec.